# EUROPÄISCHE PATENTSCHRIFT

(11) **EP 2 806 253 B1**
(45) Veröffentlichungstag und Bekanntmachung des Hinweises auf die Patenterteilung: **01.01.2020**
(21) Anmeldenummer: 14168541.2
(22) Anmeldetag: 15.05.2014
(51) Int. Cl.: G01D 21/00, G08C 19/02, H04Q 9/00, G01F 1/32

(54) **Messanordnung zur Bestimmung einer Messgröße**
Measuring arrangement for determining a measured variable
Dispositif de mesure pour déterminer une grandeur de mesure

(30) Priorität: 22.05.2013 DE 102013008598
(43) Veröffentlichungstag der Anmeldung: 26.11.2014
(73) Patentinhaber: Krohne Messtechnik GmbH, 47058 Duisburg (DE)
(72) Erfinder: Dymek, Steffen, 48147 Oberhausen (DE)
(74) Vertreter: Gesthuysen Patent- und Rechtsanwälte

(56) Entgegenhaltungen:
- DE-A1-102006 030 962
- DE-A1-102010 063 949
- US-A1- 2008 310 195

## Beschreibung

Die Erfindung betrifft eine Messanordnung zur Bestimmung mindestens einer Messgröße gemäß dem Oberbegriff von Patentanspruch 1.

Bei der vorgenannten Messgröße handelt es sich beispielsweise um den Durchfluss, den Füllstand, den pH-Wert, die elektrische Leitfähigkeit oder die Temperatur eines Mediums. Das Ausgangssignal ist vorzugsweise ein Stromsignal, so dass das Ausgangssignal eine Information über den Wert der Messgröße bzw. einen Zustand der Messanordnung in Form der Stromstärke trägt. Das Ausgangssignal ist damit insbesondere ein sogenanntes 4...20 mA-Signal. Die Messanordnung ist beispielweise ein Feld- oder Messgerät für die Anwendung im Bereich der Prozessautomatisierung. Alternativ handelt es sich bei der Messanordnung um eine Kombination von separat ausgestalteten Komponenten.

Unterschiedliche Messgeräte dienen in der modernen Prozessautomatisierung als sogenannte Feldgeräte der Bestimmung oder Überwachung von Messgrößen, um Prozesse entsprechend überwachen oder steuern zu können. Solche Messgeräte sind dabei teilweise als kompakte Einheiten ausgestaltet oder verfügen über einzelne, voneinander abgesetzte Komponenten, die für die Übertragung von Informationen bzw. Energie miteinander verbunden sind.

Prinzipiell verfügen solche Messanordnungen zumindest über eine Sensorvorrichtung, die der eigentlichen Bestimmung der Messgröße dient und häufig zumeist ein von der Messgröße abhängiges und oft elektrisches Primärsignal erzeugt. Aus dem Primärsignal oder einer davon abgeleiteten Größe lässt sich dann der eigentliche Wert der Messgröße ermitteln. Dies geschieht teilweise in der Messanordnung selbst oder in einer übergeordneten Einheit, wie beispielsweise einer Leitwarte. Für die Gewinnung des Werts der Messgröße sind beispielsweise hinterlegte Kalibrierdaten erforderlich oder es werden unterschiedliche Primärsignale verrechnet. Bei der Füllstandmessung nach dem Radar-Prinzip wird beispielsweise aus der Laufzeit eines Mikrowellensignals über Referenzdaten - insbesondere über den Abstand zwischen einer für die Messung verwendeten Antenne und dem Tank, in dem sich das Messmedium befindet - der Füllstand des die Mikrowellensignale reflektierenden Mediums ermittelt.

Der funktionelle Abschnitt zur Gewinnung des Werts der Messgröße oder zur Aufbereitung oder Umwandlung des Primärsignals, der damit der Sensorvorrichtung nachgeordnet ist und das über den Signalausgang auszugebende Ausgangssignal erzeugt, wird insbesondere bei solchen Messanordnungen, die über separate oder voneinander trennbare Komponenten verfügen, auch als Transmitter bezeichnet.

Für die Ausgabe des Messwerts oder des Primärsignals der Sensorvorrichtung oder einer davon abhängigen Größe oder auch für die Ausgabe von Informationen über den Zustand der Messanordnung beispielsweise in Form von Fehlersignalen ist üblicherweise ein Signalausgang, z. B. in Form einer Schnittstelle vorgesehen.

Das Ausgangssignal ist beispielsweise analog oder digital. In der Prozessautomatisierung ist insbesondere die Verwendung von sogenannten 4...20 mA-Signalen verbreitet. Dabei dient die Stromstärke des Ausgangssignals - zwischen 4 mA und 20 mA - als Trägerin der auszugebenden Information, indem beispielsweise die kleinste Stromstärke dem kleinsten zu erwartenden Messwert und die größte Stromstärke dem größten zu erwartenden Messwert zugeordnet sind. Zwischen diesen Grenzwerten wird häufig eine lineare Zuordnung zwischen Stromstärke und Messwert verwendet. Um Fehlerzustände zu signalisieren, werden Ausgangssignale mit Stromstärken außerhalb des 4 bis 20 mA-Bereichs erzeugt.

Um den Aufwand für die Verkabelung und auch für die Ausgestaltung der Messanordnungen bzw. Feldgeräte zu reduzieren, sind sogenannte Zweileitergeräte bekannt. Bei diesen Feld- oder Messgeräten sind nur zwei Leiter vorgesehen, so dass die Datenkommunikation und die Energieversorgung des Geräts über die gleichen Leitungen erfolgt. Daher fallen bei solchen Geräten bzw. Anordnungen der Signalausgang und der Stromeingang zusammen.

Da die Ausgangssignale zwischen 4 mA und 20 mA liegen, steht dem Feldgerät auch jeweils nur eine entsprechende Stromstärke und daher eine sich ändernde Leistung zur Verfügung. Die für den Betrieb des Feldgeräts vorhandene Leistung ist abhängig vom Messwert. Daher ist die Elektronik der Messanordnung bzw. die Steuerung der Komponenten entsprechend auszulegen. Bei vielen Messanordnungen wird angestrebt, dass bei allen Betriebszuständen - d. h. bei allen möglichen Messwerten - die Energieaufnahme stets maximal ist.

Bei den Ausgangssignalen gemäß dem 4...20 mA-Standard handelt es sich um analoge Signale. In der Prozessmesstechnik ist eine Variante, um eine digitale Kommunikation zu ermöglichen, der sogenannte HART-Standard (Highway Addressable Remote Transducer). Dabei werden die digitalen Signale dem analogen Signal überlagert. Soll eine Messanordnung auch eine Signalausgabe gemäß dem HART-Standard ermöglichen, so ist es erforderlich, dass der Signalausgang bzw. der Stromeingang einen hohen Eingangswiderstand aufweist bzw. darstellt.

Aus der DE 10 2010 063 949 A1 ist eine gattungsgemäße Messanordnung bekannt. Zur Reduzierung der Störempfindlichkeit wird vorgeschlagen, den über einem Längsregler anliegenden Spannungsabfall in Abhängigkeit von der Eingangsspannung der Messanordnung einzustellen.

Der Offenlegungsschrift DE 199 25 943 A1 lässt sich eine Messanordnung entnehmen, die aus einem Messwerterfassungsteil mit einer Sensorvorrichtung und einer Stromstellvorrichtung, aus einem Messwertauswertungsteil - also einer Art Transmitter - und einer Verbindung zwischen beiden besteht. Die Stromstellvorrichtung stellt den Strom entsprechend dem Messwert ein, was durch die direkte Steuerung durch die Sensorvorrichtung geschieht. Dabei wird die Stromaufnahme der Sensorvorrichtung so gesteuert, dass ein Spannungsabfall über die Stromstellvorrichtung möglichst klein ist.

Eine Feldgerät-Elektronik für Zweileitergeräte beschreibt die Offenlegungsschrift DE 10 2006 030 962 A1. Die Elektronik dient dazu, in dem Fall, dass die dem Feldgerät zur Verfügung stehende Energie nicht von der Sensorvorrichtung benötigt wird, die überschüssige Energie in Wärme umgewandelt wird. Dabei werden mehrere Teilströme innerhalb des Feldgeräts gemessen, werden Verbraucher abgeschaltet und wird über ein Stellglied, das auch der Spannungsbegrenzung dient, der in Wärme umzuwandelnde Strom eingestellt. Der Aufbau ist insgesamt sehr detailliert, sehr aufwändig und damit kostenintensiv. Insbesondere werden mehrere Strommessungen durchgeführt.

In der Offenlegungsschrift DE 10 2008 062 815 A1 wird eine Schaltung beschrieben, mit der bei einem Zweileitergerät überschüssige elektrische Energie nicht verbraucht, sondern gespeichert wird.

Der Erfindung liegt die Aufgabe zugrunde, eine Messanordnung vorzuschlagen, deren Leistungsaufnahme bei möglichst allen Betriebszuständen maximal ist.

Die erfindungsgemäße Messanordnung, bei der die zuvor hergeleitete und aufgezeigte Aufgabe gelöst ist, ist zunächst und im Wesentlichen durch die Merkmale des Kennzeichnungsteils von Patentanspruch 1 gekennzeichnet.

Die erfindungsgemäße Messanordnung ist in einer Ausgestaltung insbesondere als Zweileitergerät ausgestaltet, so dass der Signalausgang insbesondere auch der Energieversorgung der Messanordnung dient.

Die Stromstellvorrichtung dient der Einstellung des Ausgangssignals in Bezug auf die Stromstärke. Dies erfolgt in einer Variante dadurch, dass die Stromstellvorrichtung einen variablen Anteil der Stromstärke einstellt, der sich in Verbindung mit einem festen Anteil - gleichsam als Offset - insgesamt zu dem einzustellenden und insbesondere von dem Messwert abhängigen Wert der Stromstärke des Ausgangssignals ergänzt.

Die Regelvorrichtung steuert eine Laststromvorrichtung in Abhängigkeit von einem Spannungsabfall über der Stromstellvorrichtung. Bei der Laststromvorrichtung handelt es sich insbesondere um eine Vorrichtung, über die ein Laststrom abgeführt bzw. in Wärme dissipiert werden kann.

In einer Ausgestaltung sind die Stromstellvorrichtung, die Regelvorrichtung und die Laststromvorrichtung Komponenten der Messanordnung, die der eigentlichen Sensorvorrichtung nachgeordnet und in einer zusätzlichen Ausgestaltung sogar in einem sogenannten Transmitter zusammengefasst sind. In einer Ausgestaltung schließt sich die Stromstellvorrichtung einem Kontakt des Signalausgangs an.

Im Gegensatz zum Stand der Technik wird für die Steuerung des Verbrauchs der überschüssigen Energie lediglich ein Spannungsabfall bestimmt bzw. überwacht. Eine Messung von Teilströmen innerhalb der Messanordnung wie im Stand der Technik entfällt. Auch wird die interne Spannung nicht begrenzt.

In einer Ausgestaltung wird insbesondere lediglich die Spannung über der Stromstellvorrichtung geregelt, damit diese Stromstellvorrichtung bzw. wenigstens eine Komponente der Stromstellvorrichtung nicht in die Sättigung kommt.

In einer Ausgestaltung wird zu beiden Seiten eines Transistors - als dem in dieser Ausgestaltung entscheidenden Bestandteil der Stromstellvorrichtung - die elektrische Spannung über jeweils einen Spannungsteiler (als einer Anordnung von elektrischen Widerstandselementen) abgegriffen und werden die beiden Spannungen über einen Operationsverstärker miteinander verglichen. Eine sich ergebende Abweichung zwischen den beiden Spannungswerten - insgesamt als Maß für die über der Stromstellvorrichtung abfallende Spannung - wird dann in dieser Ausgestaltung über einen Lasttransistor als Teil der Laststromvorrichtung ausgeglichen. Durch die Verwendung des Spannungsteilers ergibt sich keine feste Spannungsdifferenz über dem Transistor der Stromstellvorrichtung. Die Spannungsdifferenz wächst aufgrund der Teilerverhältnisse der Spannungsteiler zu höheren Spannungen am Signalausgang - den sogenannten Klemmenspannungen - leicht an.

Durch die Laststromvorrichtung wird der Anteil des Stromes, der nicht von der Sensorvorrichtung benötigt wird, verbraucht. Daher kann die Leistungsaufnahme auch unabhängig vom Betriebszustand - also dem Wert der Messgröße - stets maximal sein.

Die Steuerung der Laststromvorrichtung in Abhängigkeit von der über die Stromstellvorrichtung abfallende Spannung erfolgt erfindungsgemäß wie folgt: Sinkt der Spannungsabfall über der Stromstellvorrichtung, so resultiert dies daraus, dass die nachfolgende Elektronik und insbesondere die Sensorvorrichtung nicht den ganzen zur Verfügung stehenden Strom, sondern nur einen Teil benötigt. Daher wird die Laststromvorrichtung so gesteuert, dass sich ihr Energieverbrauch erhöht. Steigt umgekehrt die über der Stromstellvorrichtung abfallende Spannung, so wird von der Sensorvorrichtung mehr Strom verbraucht und die Stromaufnahme durch die Laststromvorrichtung wird passend reduziert.

Eine solche Steuerung hat beispielsweise für die Ausgestaltung, dass die Stromstellvorrichtung über einen Transistor verfügt, den Vorteil, dass dieser Transistor im Regelbetrieb gehalten wird und nicht in die Sättigung kommen kann. Über Letzteres wird wiederum erzielt, dass der Eingangswiderstand des Signalausgangs, der mit dem Energieeingang bei einem Zweileitergerät zusammenfällt, auf einem entsprechend hoch vorgegebenen Wert bleibt, so dass die Anwendung des HART-Protokolls zur Datenkommunikation möglich ist.

In einer Ausgestaltung sind die Stromstellvorrichtung und die Laststromvorrichtung in Reihe geschaltet und in einer alternativen oder ergänzenden Ausgestaltung sind die Stromstellvorrichtung und die Regelvorrichtung parallel zueinander geschaltet.

In einer Ausgestaltung wird die Stromstellvorrichtung von mindestens einer Vorgabevorrichtung in dem Sinne gesteuert, dass die Stromstellvorrichtung von der Vorgabevorrichtung die Informationen darüber erhält, welche Stromstärke des Ausgangssignals einzustellen ist. Dabei ist die Steuerung abhängig zumindest von einem von der Sensorvorrichtung erzeugten Wert. Dieser Wert ist in einer Ausgestaltung insbesondere der Wert der zu bestimmenden Messgröße und in einer alternativen Ausgestaltung ein von der Sensorvorrichtung bei der Messung gewonnener Wert, der über eine passende Verarbeitung den Wert der zu bestimmenden Messgröße ergibt.

Bei der vorhergehenden Ausgestaltung erzeugt die Sensorvorrichtung einen Wert, der ggf. bereits der endgültige Wert der Messgröße ist oder der ggf. einer weiterer Auswertung und Aufarbeitung z. B. in Verbindung mit Kalibrierdaten bedarf. Ausgehend von diesem Wert der Sensorvorrichtung steuert die Vorgabevorrichtung die Stromstellvorrichtung und stellt dadurch den Wert der Stromstärke des Ausgangssignals ein.

Die Einstellung der Stromstärke geschieht in einer Ausgestaltung derart, dass die Stromstärke des Ausgangssignals die Summe aus dem variablen Anteil der Stromstellvorrichtung und einem festen Anteil einer zusätzlichen Vorrichtung zur Einstellung des Stroms - einer Feststromstellvorrichtung - ist.

Die Vorgabevorrichtung überwacht zusätzlich in einer Ausgestaltung das Ausgangssignal und vergleicht den am Signalausgang und damit an den zwei Leitungen/Kontakten/Klemmen der Messanordnung anliegenden Strom mit dem vorgegebenen Sollwert des Ausgangsignals. Dabei kommt in einer Ausgestaltung auch ein Sens-Widerstand für das Rücklesen des eingestellten Stroms zum Einsatz.

In einer Ausgestaltung sind die Vorgabevorrichtung und die Regelvorrichtung derartig ausgestaltet, dass sie unabhängig voneinander arbeiten. Die Regelvorrichtung steuert daher insbesondere die Laststromvorrichtung nur in Abhängigkeit von dem Spannungsabfall über die Stromstellvorrichtung und daher unabhängig von der Vorgabevorrichtung und auch derart, dass die Werte der Sensorvorrichtung nicht an die Regelvorrichtung übermittelt werden. Die Vorgabevorrichtung erhält in dieser Ausgestaltung die Information über das einzustellende Ausgangssignal von der Sensorvorrichtung und steuert davon ausgehend die Stromstellvorrichtung. Die Regelvorrichtung ihrerseits überwacht den Spannungsabfall über der Stromstellvorrichtung und steuert davon ausgehend die Laststromvorrichtung, unbeeinflusst von dem Wert der Sensorvorrichtung oder der Vorgabe durch die Vorgabevorrichtung.

In einer Ausgestaltung ist die Laststromvorrichtung zumindest teilweise als Stromverbraucher ausgestaltet. In dieser Ausgestaltung dient die Laststromvorrichtung insbesondere dem Verbrauch von elektrischer Energie, die im gegebenen Betriebszustand (also dem Zustand mit dem jeweils bestimmten Wert der Messgröße und davon abhängig dem jeweiligen Wert der Stromstärke des Ausgangssignals) insbesondere von der Sensorvorrichtung nicht benötigt bzw. verbraucht wird. Der Verbrauch von gleichsam überflüssiger Energie durch die Laststromvorrichtung wird in Abhängigkeit von dem Spannungsabfall über die Stromstellvorrichtung gesteuert.

In einer Ausgestaltung verfügt die Laststromvorrichtung über wenigstens einen Transistor.

Erfindungsgemäß steuert die Regelvorrichtung die Laststromvorrichtung derartig, dass bei sinkendem Spannungsabfall über der Stromstellvorrichtung ein Verbrauch an elektrischer Energie durch die Laststromvorrichtung steigt. Alternativ oder ergänzend steuert die Regelvorrichtung die Laststromvorrichtung derartig, dass bei steigendem Spannungsabfall über der Stromstellvorrichtung ein Verbrauch an elektrischer Energie durch die Laststromvorrichtung sinkt.

Der weiteren Messanordnung widmet sich die Ausgestaltung, der gemäß mindestens eine Feststromstellvorrichtung vorgesehen ist, die einen vorgebbaren festen Wert für die Stromstärke des Ausgangssignals einstellt. Bei dieser Ausgestaltung ergibt sich insgesamt der Wert der Stromstärke des Ausgangssignals aus dem festen Wert, der von der Feststromstellvorrichtung eingestellt wird, und aus einem variablen Wert, der von der Stromstellvorrichtung eingestellt wird.

Die Feststromstellvorrichtung dient in einer Ausgestaltung insbesondere auch als Startstromquelle, um einen Grundbetrieb der Messanordnung zu gewährleisten. Dies insbesondere für den Fall, dass die Stromstellvorrichtung bzw. insbesondere ein Transistor als Bestandteil der Stromstellvorrichtung ohne bereits vorhandene Energie nicht angesteuert werden kann.

In einer Ausgestaltung weist die Stromstellvorrichtung mindestens einen Transistor auf. Dabei steuert die Regelvorrichtung die Laststromvorrichtung derartig, dass der Transistor der Stromstellvorrichtung außerhalb einer Sättigung bleibt. In dieser Ausgestaltung wird dafür Sorge getragen, dass der Transistor nicht in die Sättigung gerät und damit nicht mehr steuerbar wäre.

Die Ausgestaltung mit einem Transistor in der Stromstellvorrichtung lässt sich insbesondere mit der Ausgestaltung kombinieren, in der die Stromstellvorrichtung und die Laststromvorrichtung als Verbraucher von elektrischer Energie in Reihe liegen. Durch die entsprechende Steuerung der Laststromvorrichtung durch die Regelvorrichtung wird die Sättigung des Transistors verhindert.

In einer Ausgestaltung wird durch eine Verhinderung der Sättigung auch gewährleistet, dass der Eingangswiderstand des Signalausgangs stets hoch bleibt und nicht absinkt.

In einer weiteren Ausgestaltung ist die Laststromvorrichtung parallel zum Signalausgang und parallel zur Sensorvorrichtung geschaltet.

In einer Ausgestaltung ist vorgesehen, dass die Sensorvorrichtung der Durchflussmessung nach dem Vortex-Prinzip dient. Eine alternative Ausgestaltung sieht vor, dass der Durchfluss als Messgröße durch eine MID-Sensorvorrichtung oder nach dem Coriolis-Durchflussmessprinzip gemessen wird. Alternativ dient die Sensorvorrichtung der Füllstands- bzw. Abstandsmessung nach dem Radarprinzip. Andere Messmethoden lassen sich ebenfalls umsetzen.

Im Einzelnen gibt es eine Vielzahl von Möglichkeiten, die erfindungsgemäße Messanordnung auszugestalten und weiterzubilden. Dazu wird verwiesen einerseits auf die dem Patentanspruch 1 nachgeordneten Patentansprüche, andererseits auf die folgende Beschreibung von Ausführungsbeispielen in Verbindung mit der Zeichnung. In der Zeichnung zeigen
- Fig. 1: eine schematische, im Wesentlichen die funktionalen Wirkzusammenhänge anhand eines Blockschaltbilds verdeutlichende Darstellung einer erfindungsgemäßen Messanordnung,
- Fig. 2: einen vergrößerten Ausschnitt eines Teils der Messanordnung der Fig. 1 und
- Fig. 3: eine schematische Darstellung einer Sensorvorrichtung zur Verwendung in einer Messanordnung gemäß der Fig. 1.

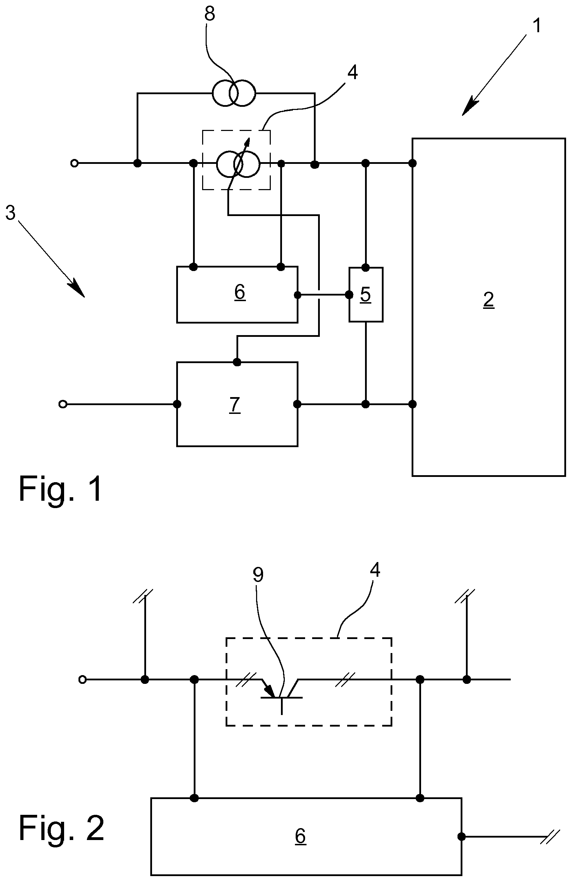

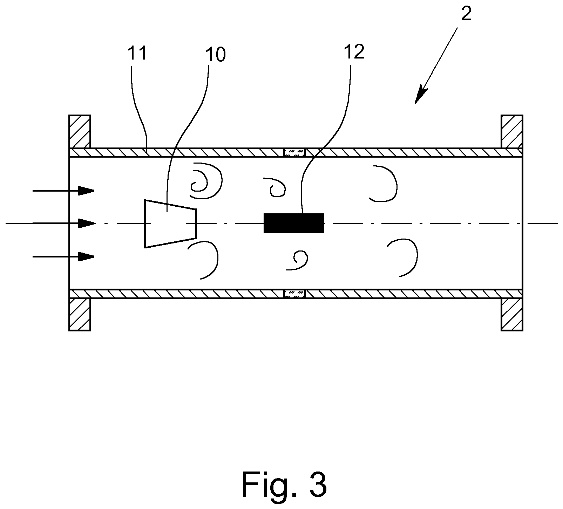

In der Fig. 1 ist ein Ausführungsbeispiel einer Messanordnung 1 dargestellt, wobei die Figur keine Darstellung im Sinne eines korrekten elektrischen Schaltplans ist, sondern vielmehr die Wirkzusammenhänge zwischen den verschiedenen Bestandteilen der Messanordnung 1 erkennen lassen. Die Fig. 2 zeigt einen Teil der Messanordnung 1 der Fig. 1, und Fig. 3 gibt ergänzend ein Beispiel für eine Sensorvorrichtung 2 schematisiert wieder.

Die Fig. 1 zeigt schematisch den Aufbau einer Messanordnung 1, die hier insbesondere als kompaktes, einteiliges Feldgerät ausgeführt ist. Für die Bestimmung einer Messgröße ist eine Sensorvorrichtung 2 vorgesehen, die beispielsweise der Durchflussmessung eines fließfähigen Mediums durch eine Rohrleitung dient.

Der von der Messanordnung 1 bestimmte Wert der Messgröße wird über den Signalausgang 3 als 4...20 mA-Signal ausgegeben. Dabei wird eine Zuordnung zwischen der Stromstärke und dem Wert der Messgröße verwendet. Da das Feldgerät als Messanordnung 1 in der gezeigten Ausgestaltung als sogenanntes Zweileitergerät ausgeführt ist, dient der Signalausgang 3 gleichzeitig auch als Eingang an elektrischer Energie.

Für die Einstellung der Stromstärke des Ausgangssignals und damit letztendlich für die Ausgabe des Werts für die Bestimmung der Messgröße ist u. a. die Stromstellvorrichtung 4 vorgesehen.

Bei der erfindungsgemäßen Messanordnung 1 wird für jeden Messwert und damit auch für jeden Betriebszustand über den Signalausgang 3 die jeweils maximal verfügbare elektrische Energie bezogen. Gleichzeitig wird auch noch gewährleistet, dass der Signalausgang 3 auch bei jedem Betriebszustand den gleichen und dadurch über die Ausgestaltung des Signalausgangs 3 gleich hohen Ausgangswiderstand aufweist. Dies erlaubt es, über den Signalausgang 3 auch eine Datenkommunikation nach dem HART-Standard durchzuführen.

Für diese Eigenschaften der Messanordnung 1 ist in der dargestellten Umsetzung eine Laststromvorrichtung 5 in Reihe zur Stromstellvorrichtung 4 angeordnet. Die Laststromvorrichtung 5 dient im Wesentlichen dazu, überschüssige - also insbesondere von der Sensorvorrichtung 2 nicht benötigte - elektrische Energie zu verbrauchen und sie beispielsweise in Wärme umzuwandeln. Dabei ist die Laststromvorrichtung 5 in der gezeigten Ausgestaltung parallel zur Sensorvorrichtung 2 geschaltet. In einer Ausgestaltung ist wenigstens ein - hier nicht dargestellter - Transistor als Teil der Laststromvorrichtung 5 vorgesehen.

Das Maß der von der Laststromvorrichtung 5 z. B. in Wärme zu dissipierenden elektrischen Energie richtet sich nach dem Spannungsabfall über der Stromstellvorrichtung 4. Die Überwachung des Spannungsabfalls und die davon ausgehende Steuerung der Laststromvorrichtung 5 erfolgt durch die Regelvorrichtung 6. In einer Ausgestaltung werden in der Regelvorrichtung 6 zwei Spannungen - eine vor und eine nach der Stromstellvorrichtung 4 bzw. wenigstens einer Komponente der Stromstellvorrichtung 4 über jeweils einen - hier nicht dargestellten - Spannungsteiler gemessen, um einen Wert für den Spannungsabfall über die Stromstellvorrichtung 4 zu erhalten. Die beiden Spannungen werden dann über einen - hier nicht dargestellten - Operationsverstärker miteinander verglichen, wobei bei einer Abweichung die Laststromquelle 5 passend nachgeregelt wird.

Die Stromstellvorrichtung 4 wird von der Vorgabevorrichtung 7 gesteuert, die von der Sensorvorrichtung 2 einen über das Ausgangssignal zu übertragenden Wert erhält. Der Anteil der Stromstärke, die durch die Stromstellvorrichtung 4 eingestellt wird, ist ein variabler Anteil, der sich mit einem festen Anteil, der durch die parallel zur Stromstellvorrichtung 4 angeordnete Feststromstellvorrichtung 8 vorgegeben wird, insgesamt zu der Stromstärke des Ausgangssignals ergänzt, die dem Wert der Sensorvorrichtung 2 und damit in der gezeigten Ausgestaltung insbesondere auch dem Wert der Messgröße zugeordnet ist.

Durch die Feststromstellvorrichtung 8 ist gleichzeitig auch ein Minimalstrom gegeben, der ein Anlaufen der Elektronik der Messanordnung ermöglicht, da für das Betreiben der Stromstellvorrichtung 4 Strom erforderlich ist.

Die Regelvorrichtung 6 und die Vorgabevorrichtung 7 sind unabhängig voneinander ausgeführt, und der Wert der Sensorvorrichtung 2 gelangt auch nicht zur Regelvorrichtung 6. Die Regelvorrichtung 6 überwacht lediglich den Spannungsabfall über der Stromstellvorrichtung 4 und steuert auch die Laststromvorrichtung 5 nur in Abhängigkeit von diesem Spannungsabfall.

In der Fig. 2 ist gezeigt, dass die Stromstellvorrichtung 4 über wenigstens einen Transistor 9 verfügt. Werden die Spannungen vor und hinter diesem Transistor 9 ermittelt und wird durch die Laststromvorrichtung 5 bei einer Abweichung der Spannungen voneinander das jeweils angemessene Quantum elektrischer Energie verbraucht, so kann insbesondere damit auch verhindert werden, dass der Transistor 9 in Sättigung gerät.

Die Fig. 3 zeigt als Beispiel für eine Sensorvorrichtung 2 ein Vortex-Durchflussmessgerät für fließfähige Medien (angedeutet durch die Pfeile). Das Messprinzip von solchen Messgeräten beruht darauf, dass sich in einem fließfähigen Medium hinter einem Staukörper 10, der von dem Medium in einem Messrohr 11 umströmt wird, eine sogenannte Kármánsche Wirbelstraße ausbilden kann, die durch sich mit der Strömung fortbewegende und sich von dem Staukörper 10 ablösende Wirbel gebildet ist. Die Frequenz, mit der sich die Wirbel vom Staukörper 10 ablösen, ist von der Strömungsgeschwindigkeit abhängig, wobei der Zusammenhang unter gewissen Bedingungen nahezu linear ist. Über die Messung der Wirbelfrequenz mit einer Aufnahmeeinheit 12 kann daher die Strömungsgeschwindigkeit des Mediums bestimmt werden.

## Patentansprüche

1. Messanordnung (1) zur Bestimmung mindestens einer Messgröße mit mindestens einer Sensorvorrichtung (2), mit mindestens einem Signalausgang (3) zur Ausgabe mindestens eines Ausgangssignals und mit mindestens einer Stromstellvorrichtung (4) zur Einstellung der Stromstärke des Ausgangssignals,
wobei mindestens eine Laststromvorrichtung (5) vorgesehen ist, wobei mindestens eine Regelvorrichtung (6) vorgesehen ist, und wobei die Regelvorrichtung (6) mindestens ausgehend von einem Spannungsabfall über der Stromstellvorrichtung (4) die Laststromvorrichtung (5) steuert,
**dadurch gekennzeichnet,**
**dass** die Laststromvorrichtung (5) zumindest teilweise als Stromverbraucher ausgestaltet ist und dass die Regelvorrichtung (6) die Laststromvorrichtung (5) derartig steuert, dass bei sinkendem Spannungsabfall über der Stromstellvorrichtung (4) ein Verbrauch an elektrischer Energie durch die Laststromvorrichtung (5) steigt und/oder dass bei steigendem Spannungsabfall über der Stromstellvorrichtung (4) ein Verbrauch an elektrischer Energie durch die Laststromvorrichtung (5) sinkt.

2. Messanordnung (1) nach Anspruch 1, **dadurch gekennzeichnet, dass** die Stromstellvorrichtung (4) und die Laststromvorrichtung (5) in Reihe geschaltet sind.

3. Messanordnung (1) nach Anspruch 1 oder 2, **dadurch gekennzeichnet, dass** die Stromstellvorrichtung (4) und die Regelvorrichtung (6) parallel zueinander geschaltet sind.

4. Messanordnung (1) nach einem der Ansprüche 1 bis 3, **dadurch gekennzeichnet, dass** mindestens eine Vorgabevorrichtung (7) vorgesehen ist, die abhängig zumindest von einem von der Sensorvorrichtung (2) erzeugten Wert die Stromstellvorrichtung (4) steuert.

5. Messanordnung (1) nach Anspruch 4, **dadurch gekennzeichnet, dass** die Vorgabevorrichtung (7) und die Regelvorrichtung (6) unabhängig voneinander arbeiten.

6. Messanordnung (1) nach einem der Ansprüche 1 bis 5, **dadurch gekennzeichnet, dass** mindestens eine Feststromstellvorrichtung (8) vorgesehen ist, die einen vorgebbaren festen Wert für die Stromstärke des Ausgangssignals einstellt.

7. Messanordnung (1) nach einem der Ansprüche 1 bis 6, **dadurch gekennzeichnet, dass** die Stromstellvorrichtung (4) mindestens einen Transistor (9) aufweist und dass die Regelvorrichtung (6) die Laststromvorrichtung (5) derartig steuert, dass der Transistor (9) außerhalb einer Sättigung bleibt.

8. Messanordnung (1) nach einem der Ansprüche 1 bis 7, **dadurch gekennzeichnet, dass** die Laststromvorrichtung (5) parallel zum Signalausgang (3) und parallel zur Sensorvorrichtung (2) geschaltet ist.

## Claims

1. Measuring arrangement (1) for determining at least one measured value with at least one sensor device (2), having at least one signal outlet (3) for output of at least one output signal and having at least one current-adjusting device (4) for adjusting the current of the output signal,
wherein at least one load current device (5) is provided, wherein at least one regulating device (6) is provided, and wherein the regulating device (6) controls the load current device (5) based on a voltage drop across the current-adjusting device (4)
**characterized in**
**that** the load current device (5) is designed at least partially as a current consumer and that the regulating device (6) controls the load current device (5) in such a way that, when the voltage drop across the current-adjusting device(4) decreases, a consumption of electrical energy rises by the load current device (5) and/or, when the voltage drop across the current-adjusting device (4) increases, a consumption of electrical energy falls by the load current device (5).

2. Measuring arrangement (1) according to claim 1, **characterized in that** the current-adjusting device (4) and the load current device (5) are connected in series.

3. Measuring arrangement (1) according to claim 1 or 2, **characterized in that** the current-adjusting device (4) and the regulating device (6) are connected in parallel.

4. Measuring arrangement (1) according to any one of claims 1 to 3, **characterized in that** at least one selection device (7) is provided, which controls the current-adjusting device (4) depending on at least one value generated by the sensor device (2).

5. Measuring arrangement (1) according to claim 4, **characterized in that** the selection device (7) and the regulating device (6) operate independently of one another.

6. Measuring arrangement (1) according to any one of claims 1 to 5, **characterized in that** at least one fixed-current-adjusting device (8) is provided, which adjusts a predetermined fixed value for the current of the output signal.

7. Measuring arrangement (1) according to any one of claims 1 to 6, **characterized in that** the current-adjusting device (4) has at least one transistor (9) and that the regulating device (6) controls the load current device (5) in such a manner that the transistor (9) remains below saturation.

8. Measuring arrangement (1) according to any one of claims 1 to 7, **characterized in that** the load current device (5) is connected in parallel to the signal outlet (3) and in parallel to the sensor device (2).

## Revendications

1. Dispositif de mesure (1) pour déterminer au moins une grandeur de mesure, comprenant au moins un dispositif capteur (2), au moins une sortie de signal (3) pour délivrer au moins un signal de sortie et au moins un dispositif de réglage de courant (4) pour régler l'intensité de courant du signal de sortie,
dans lequel il est prévu au moins un dispositif de courant de charge (5),
dans lequel il est prévu au moins un dispositif de régulation (6), dans lequel le dispositif de régulation (6) commande le dispositif de courant de charge (5) au moins à partir d'une chute de tension à travers le dispositif de réglage de courant (4),
**caractérisé en ce que** le dispositif de courant de charge (5) est conçu au moins partiellement en tant que consommateur de courant et **en ce que** le dispositif de régulation (6) commande le dispositif de courant de charge (5) de manière à ce que, lorsque la chute de tension à travers le dispositif de réglage de courant (4) diminue, une consommation d'énergie électrique par le dispositif de courant de charge (5) augmente et/ou lorsque la chute de tension à travers le dispositif de réglage de courant (4) augmente, une consommation d'énergie électrique par le dispositif de courant de charge (5) diminue.

2. Dispositif de mesure (1) selon la revendication 1, **caractérisé en ce que** le dispositif de réglage de courant (4) et le dispositif de courant de charge (5) sont connectés en série.

3. Dispositif de mesure (1) selon la revendication 1 ou 2, **caractérisé en ce que** le dispositif de réglage de courant (4) et le dispositif de commande (6) sont connectés en parallèle.

4. Dispositif de mesure (1) selon l'une des revendications 1 à 3, **caractérisé en ce qu'**il est prévu au moins un dispositif de préréglage (7) qui commande le dispositif de réglage de courant (4) en fonction d'au moins une valeur générée par le dispositif capteur (2) .

5. Dispositif de mesure (1) selon la revendication 4, **caractérisé en ce que** le dispositif de préréglage (7) et le dispositif de régulation (6) fonctionnent indépendamment l'un de l'autre.

6. Dispositif de mesure (1) selon l'une des revendications 1 à 5, **caractérisé en ce qu'**il est prévu au moins un dispositif de réglage de courant fixe (8) qui règle une valeur fixe préréglable de l'intensité de courant du signal de sortie.

7. Dispositif de mesure (1) selon l'une des revendications 1 à 6, **caractérisé en ce que** le dispositif de réglage de courant (4) comporte au moins un transistor (9) et **en ce que** le dispositif de régulation (6) commande le dispositif de courant de charge (5) de manière à ce que le transistor (9) reste insaturé.

8. Dispositif de mesure (1) selon l'une des revendications 1 à 7, **caractérisé en ce que** le dispositif de courant de charge (5) est connecté en parallèle avec la sortie de signal (3) et en parallèle avec le dispositif capteur (2).
